Europäisches Patentamt

European Patent Office

Office européen des brevets

(19)

(11) Veröffentlichungsnummer: **0 153 902**

**A2**

(12)  **EUROPÄISCHE PATENTANMELDUNG**

(21) Anmeldenummer: 85730013.1

(22) Anmeldetag: 31.01.85

(51) Int. Cl.⁴: **H 01 L 29/743**
**H 01 L 29/80**

(30) Priorität: 08.02.84 DE 3404834

(43) Veröffentlichungstag der Anmeldung:
04.09.85 Patentblatt 85/36

(84) Benannte Vertragsstaaten:
AT BE CH DE FR GB IT LI LU NL SE

(71) Anmelder: Hahn-Meitner-Institut für Kernforschung
Berlin GmbH
Glienicker Strasse 100
D-1000 Berlin 39(DE)

(72) Erfinder: Fahrner, Wolfgang, Dr. rer. nat.
Glienicker Strasse 66
D-1000 Berlin 39(DE)

(72) Erfinder: Bräunig, Dietrich, Dr.
Franzensbader Strasse 14
D-1000 Berlin 33(DE)

(72) Erfinder: Knoll, Meinhard, Dr.-Ing.
Gasteiner Strasse 13
D-1000 Berlin 41(DE)

(72) Erfinder: Laschinski, Joachim, Dipl.-Ing.
Rubensstrasse 72
D-1000 Berlin 41(DE)

(74) Vertreter: Wolff, Konrad
Heinrich-Hertz-Institut für Nachrichtentechnik Berlin
GmbH Einsteinufer 37
D-1000 Berlin 10(DE)

(54) Halbleiter-Leistungsbauelement, insbesondere Thyristor und Gridistor, sowie Verfahren zu dessen Herstellung.

(57) Es wird ein Verfahren zur Herstellung eines Halbleiter-Leistungsbauelementes, insbesondere Thyristor und Gridistor beschrieben.

Bei einem solchen Leistungsbauelement soll eine vergrabene Gitterstruktur 10 in das Halbleitermaterial 1, insbesondere Silizium, unter Verwendung einer metallischen Gittermaske 5, 8 eingebracht werden. Erfindungsgemäß ist vorgesehen, daß die vergrabene Gitterstruktur 10, 11 mittels gegendotierender Ionenimplantation 9 unter Verwendung eines Hochenergiebeschleunigers durch die metallische Gittermaske 5, 8 hindurch unmittelbar innerhalb des Halbleitermaterials 1 gebildet wird. Da die Stege 8 der metallischen Gittermaske 5 ein Bremsvermögen der Ionenbestrahlung entgegensetzen, werden zwei vertikal separierte und seitlich gegeneinander versetzte Gitterstrukturen 10, 11 im Halbleitermaterial 1 ausgebildet. Durch den seitlichen Anschliff 7 des Halbleitermaterials 1 werden gleichzeitig die Leiterstrukturen 12, 13 zwischen den vergrabenen Gitterstrukturen 10,11 und der Steuer-/Schaltelektrode 4 ausgebildet, welche sich auf der Unterseite 2 des Halbleitermateriales 1 befindet.

Fig.4

Hahn-Meitner- Institut für Kernforschung Berlin GmbH
51/0384 DE

Halbleiter -Leistungsbauelement, insbesondere Thyristor
und Gridistor, sowie Verfahren zu dessen Herstellung

Die Erfindung bezieht sich auf ein Halbleiter-Leistungsbauelement , insbesondere Thyristor und Gridistor,
sowie auf ein Verfahren zu dessen Herstellung.

Es sind zwei Arten von Gitterstrukturen für Halbleiter-
Leistungsbauelemente bekannt, nämlich die Oberflächen-
Gitterstruktur und die vergrabene Gitterstruktur
(IEEE Transactions on Electron Devices Vol. ED-27,No.
11, November 1980,Seiten 2141 bis 2145). Zur Herstellung
eines Halbleiter- Leistungsbauelementes mit einer vergrabenen Gitterstruktur wird ein $n^-$ - dotiertes Halbleitermaterial, z.B. ein Silizium- Plättchen auf seiner
Oberfläche durch thermische Oxidation mit einer Maskierungsschicht versehen. In die Randbereiche des
Plättchens werden Fenster eingeätzt ,durch welche mittels
planarer Diffusion von Bor die Gitteranschlüsse ausgebildet werden. Gleichzeitig wird auf der Unterseite des
Plättchens im gleichen Bor-Diffusions- Zyklus die
$p^+$ - Anode ausgebildet. Anschließend wird die Oxid-
Maskierungsschicht im aktiven Bereich des Plättchens
durch Ätzen mit einem Streifenmuster versehen, welches
einer metallischen Gittermaske entspricht. Zwischen den
Maskenstreifen wird durch Bor -Diffusion das Gitter in
die Oberfläche des Plättchens eingebracht. Anschließend
wird im wesentlichen oberhalb der gesamten Fläche der
so gebildeten Oberflächen-Gitterstruktur ein Fenster
aus der Oxid-Maskenschicht herausgeätzt, in welchem
durch Epitaxie mittels flüssigem Silizium eine $n^+$-
dotierte Epitaxie-Schicht über die Gitterstruktur gebracht wird. Hierdurch wird eine vergrabene Gitterstruktur in das Halbleitermaterial eingebracht. Schließlich müssen in einem weiteren Arbeitsschritt noch die
unbedeckten Randbereiche der Gitterstruktur in einer
nachfolgenden Gitter- Kontakt-Metallisierung mit den
Gitter-Anschlußkontakten leitend verbunden werden.

Mit dem bekannten Verfahren wird beispielsweise bei der
Herstellung eines Gridistors ein gegendotiertes, leitfähiges Gitter im Sinne der Vakuum-Röhrenanalogie in
einen Halbleiter eingebracht. Hierzu sind eine Vielzahl von Maskierungsschritten und Ätzvorgängen notwendig, da das Verfahren der Epitaxie die Aufbringung eines
Netzes gegendotierenden Materials auf die Halbleiteroberfläche und das anschließende Aufwachsen des Grundmaterials durch weitere Epitaxie über das Netz erfordert,
so daß das Netz als vergrabene Gitterstruktur ausgebildet werden kann. Das bekannte Verfahren zur Herstellung eines Halbleiter- Leistungsbauelementes, insbesondere eines Gridistors ist von daher sehr aufwendig
in der Anzahl der Arbeitsschritte.

Der Erfindung liegt von daher die Aufgabe zugrunde, ein
Verfahren zu Herstellung eines Halbleiter- Leistungsbauelementes, insbesondere Thyristor und Gridistor ,
zu schaffen, bei welchem mit einer möglichst kleinen
Anzahl von Maskierungsschritten und Ätzvorgängen eine
vergrabene Gitterstruktur im Halbleitermaterial, insbesondere einem Silizium-Plättchen ausgebildet werden
kann.

Zur Lösung dieser Aufgabe sieht die Erfindung vor, daß
die vergrabene Gitterstruktur mittels gegendotierender
Ionenimplantation unter Verwendung eines Hochenergiebeschleunigers durch die metallische Gitterstruktur hindurch unmittelbar innerhalb des Halbleitermaterials gebildet wird. Hierzu ist nur ein einziger Maskierungsschritt notwendig, d.h. es muß nur eine einzige metallische Gittermaske aus der Oxid-Oberfläche des Halbleitermaterials herausgeätzt werden. Durch die erfindungsgemäß durch die metallische Gittermaske hindurch vorgenommene gegendotierende Ionenimplantation
kann damit das vergrabene Gitter unmittelbar innerhalb
des Halbleitermaterials ausgebildet werden, da aufgrund
des Bremsvermögens der Stege der metallischen Gittermaske zunächst nur zwischen diesen Stegen Ionen in das
Halbleitermaterial implantiert werden können, welche die
vergrabene Gitterstruktur unmittelbar ausbilden. Da
das Gitter in Tiefen von mehr als 10 μm, vorzugsweise
mehr als 50μm liegen sollte, wird der Einsatz eines
Hochenergiebeschleunigers des 100 MeV -Bereichs vorgeschlagen.

Die Drahtdicke des vergrabenen Gitters in Richtung der
Halbleitertiefe, d.h. in Implantationsrichtung ist durch
die physikalische Grenze der Ionenhalbwertsbreite
bestimmt, wie es in der DE-P 33 23 672.0 vom 1.7. 1983
beschrieben worden ist. Die seitliche Drahtdicke muß
durch eine definierte metallische Gittermaske bestimmt
werden. Die dabei auftretenden Probleme bestehen in
Genauigkeitsanforderungen an die metallische Gittermaske und in der Durchschleifung der Gitterdrähte an
einen äußeren Kontakt für die Steuer-/ Schaltelektrode.
Dabei ist zu berücksichtigen, daß der laterale Gitterabstand den Wert der doppelten Raumladungszone, die durch
eine typische angelegte Sperrspannung erzielt wird, nicht
überschreiten darf. Je nach Dotierung und Spannung
ergeben sich hier Werte im 10μm-Bereich. Gleichzeitig
muß die Maske eine Tiefe bzw. Dicke ihrer Stege haben, die
wesentlich größer ist als die Eindringtiefe der Ionen in
diese Maske ( typisch im 100μm-Bereich). Außerdem muß

die Gittermaske so exakt rechtwinklig sein, daß keine Halbschatteneffekte und damit mögliche Kurzschlüsse auftreten. Solche Masken mit einem Verhältnis von Maskentiefe zum Gitterabstand, das größer als 10 ist, sind praktisch nicht zu realisieren. Eine weitere Ausbildung der Erfindung besteht zur Behebung dieser Probleme in der Verlagerung von der lateralen zur vertikalen Separation und in der Schräganschleifung des Halbleitermaterials. Erfindungsgemäß ist hierzu vorgesehen, daß das Material und die Dicke der Gittermaske so gewählt werden, daß auch durch die Stege der Gittermaske hindurch Ionen im Halbleitermaterial implantiert werden können, so daß zwei vertikal separierte und seitlich gegeneinander versetzte Gitterstrukturen im Halbleitermaterial ausgebildet werden. Schließlich ist erfindungsgemäß vorgesehen, daß die Umfangsfläche des Halbleitermaterials von dessen Oberseite her unter einem spitzen Winkel angeschliffen wird, daß die Steuer-/Schaltelektrode auf der Unterseite des Halbleitermaterials ausgebildet wird und daß durch die Ionenimplantation gleichzeitig parallel zu den Anschliffkanten zwischen den vergrabenen Gitterstrukturen und der Steuer-/Schaltelektrode vergrabene Leiterstrukturen ausgebildet werden. Der Anschliffwinkel beträgt zwischen 10 und 60°, vorzugsweise zwischen 10 und 30°. An dem vergleichbaren System SiO$_2$ mit Masken ist in Versuchen nachgewiesen worden, daß die Tiefenseparation der beiden vergrabenen Gitterstrukturen im gewünschten Bereich liegt, d.h. daß der Übergang von der oberen zur unteren Gitterstruktur innerhalb der Nachweisgrenze von 4μm liegt. Es sind somit keine Kurzschlüsse zwischen den beiden vergrabenen Gitterstrukturen zu erwarten. Das Herstellverfahren für eine solche metallische Gittermaske kann gut beherrscht werden. Erfindungsgemäß erfolgt die Herstellung eines Halbleiter-Leistungsbauelementes, insbesondere eines Gridistors mit einem einzigen Maskenschritt und einem Schräganschliff, so daß das Leistungsbauelement auf einfache Weise herge- stellt werden kann. Dabei erfolgt gleichzeitig ein selbstjustierender Anschluß an die Steuer-/Schaltelektrode.

Das erfindungsgemäße Verfahren ist anhand eines in den Zeich- nungen dargestellten Ausführungsbeispieles eines Halb- leiter- Leistungsbauelementes in Form eines Gridistors näher erläutert. Es zeigen:

Fig. 1 bis 4  Vertikalschnitte durch das Leistungs- bauelement in verschiedenen Verfahrens- schritten,

Fig. 5  eine vergrößerte Schnittdarstellung des Halbleiter-Leistungsbauelementes während der Ionenimplantation von zwei vergrabenen Gitterstrukturen durch eine aufliegende metallische Gittermaske und

Fig. 6  eine perspektivische Darstellung eines Halbleiter- Leistungsbauelementes während der Ionenimplantation einer einzigen vergrabenen Gitterstruktur unter Anwendung einer metallischen Gittermaske von großer Maskendicke bzw.- tiefe.

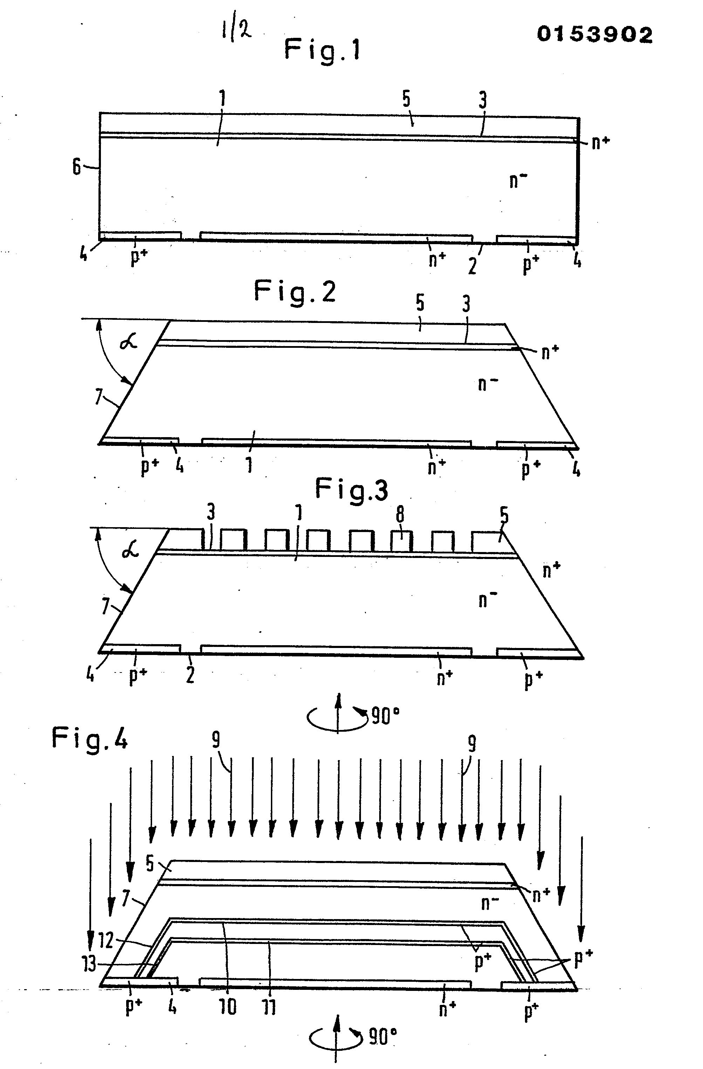

Das in Fig. 1 dargestellte $n^-$-dotierte Ausgangsmaterial 1 ist ein phosphor-dotiertes Silizium mit einer Konzentra- tion von $10^{13}/cm^3$. Das Ausgangsmaterial 1 ist eine zylindrische Scheibe mit einem Durchmesser von 3/4 " (19mm) und von ungefähr 900 μm Dicke. In den mittleren Bereich der Oberfläche der Unterseite 2 und in die gesamte Oberseite 3 werden $n^+$-Kontakte mit einer Konzentration von $10^{19}/cm^3$ und einer Eindringtiefe von 50 - 80 μm diffundiert. Am umlaufenden Rand der Unterseite 2 wird in Form einer Ringscheibe ein Bor enthaltender $p^+$-
Kontakt 4 mit einer Konzentration von $10^{18}/cm^3$ bis
$10^{19}/cm^3$ eindiffundiert. Anschließend erfolgt eine
Metallisierung der Oberseite 3 durch Aufdampfen einer
Metallschicht 5, insbesondere Aluminium, in einer Dicke
von 50μm bis 100μm.

Dann erfolgt gemäß Fig. 2 ein Anschleifen der Umfangsflächen 6 unter einem Winkel $\alpha$, der zwischen 10 und 60°,
vorzugsweise zwischen 10 und 30° beträgt und der ausgehend von der Ebene der Oberseite 3 gemessen wird. Durch
den Schräganschliff wird das Ausgangsmaterial 1 mit einer
kegelstumpfförmigen Mantelfläche 7 versehen. Das Anschleifen erfolgt mittels einer Schleifmaschine. Anschließend erfolgt noch ein Lackieren des Bauelementes
mit Fotolack in einer im μ-Bereich liegenden Dicke.

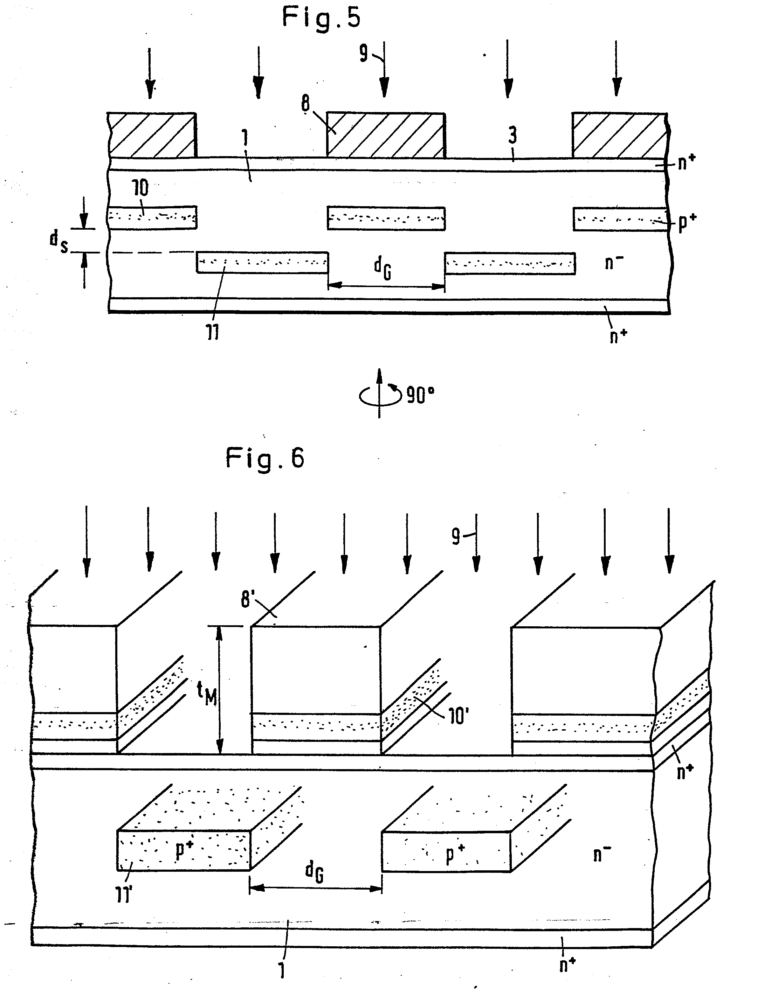

Der nächste Verfahrensschritt sieht die Ausbildung der
metallischen Gittermaske innerhalb der Metallschicht 5
vor. Hierzu wird gemäß Fig. 3, welche gegenüber Fig. 2
um 90° gedreht ist, eine Streifenstruktur aus der Metallschicht 5 zur Bildung von Stegen 8 herausgeätzt. Der
Abstand zweier Stege voneinander und die Dicke eines
jeden Steges ( mit Ausnahme der Randstege) beträgt 100μm.
Das Ätzen erfolgt auf einer Plasmaätzanlage.

Schließlich folgt der wesentliche Schritt der gegendotierenden Ionenimplantation gemäß Fig. 4, in welcher
das Leistungsbauelement wiederum um 90° gegenüber Fig. 3
gedreht worden ist. Zur gegendotierenden Ionenimplantation wird das Leistungsbauelement in einem Hochenergiebeschleuniger einer energiereichen Ionenstrahlung
9 ausgesetzt. Als Hochenergiebeschleuniger wird eine
Van - de -Graaff Cyklotron-Kombination für schwere Ionen
(VICKSI) verwendet, der Hochenergiebeschleuniger
arbeitet in einem Bereich von 80 bis 100 MeV und erreicht Eindringtiefen der Ionen, welche am Beispiel von Bor im Bereich von 200 µm bis 280 µm liegen. Die Ionen- Konzentration beträgt $10^{14}/cm^2$ .... $10^{15}/cm^2$.

Durch die gegendotierende Ionenimplantation werden zwei vergrabene Gitterstrukturen 10,11 unmittelbar innerhalb des Halbleitermaterials 1 ausgebildet, wobei die vergrabenen Gitterstrukturen 10,11 vertikal voneinander separiert und seitlich gegeneinander versetzt sind.

Die wiederum um 90° gegen Fig. 4 gedrehte Fig. 5, welche einen vergrößerten Ausschnitt aus dem Leistungsbauelement 1 darstellt, zeigt einzelne Gitterdrähte einer jeden vergrabenen Gitterstruktur 10,11, welche mit einer Tiefenseparation $d_S$ eines gewünschten Bereiches angeordnet sind, welcher innerhalb der Nachweisgrenze von 4µm liegt. Der Gitterabstand $d_G$ entspricht der Breite eines Steges 8, der auf dem Halbleitermaterial 1 befindlichen metallischen Gittermaske 5.

Die schräg angeschliffene Umfangsfläche 7 ermöglicht die Kontaktverbindungen 12,13 zwischen den beiden vergrabenen Gitterstrukturen 10 bzw. 11 und der $p^+$-dotierten Steuer-/Schaltelektrode 4. Diese werden als selbstjustierte Anschlüsse unmittelbar durch die in zwei Ebenen in das Basismaterial 1 eindringenden Ionen ausgebildet.

Die Fig. 6 zeigt die Verwendung einer metallischen Gittermaske 8', deren Maskentiefe $t_M$ wesentlich größer ist als die Eindringtiefe der Ionen in diese Maske. Somit kann nur eine einzige vergrabene Gitterstruktur 11' mit einem Gitterabstand $d_G$ von der Breite eines Steges 8'der metallischen Gittermaske gebildet werden, wohingegen die durch die Stege 8'verlaufenden Ionen von dem Material des Steges 8'derart gebremst werden, daß diese in einer Schicht 10' noch innerhalb der Stege 8 implantiert werden. Die metallische Gittermaske wird jedoch zusammen mit den Stegen 8' und den implantierten Ionenschichten 10' bei der weiteren Ausbildung des Halbleiter-Leistungsbauelementes vollständig weggeätzt.

0153902

Hahn-Meitner-Institut für Kernforschung Berlin GmbH
51/0284 DE

Patentansprüche

1. Verfahren zur Herstellung eines Halbleiter -
Leistungsbauelementes, insbesondere Thyristor und
Gridistor, durch Einbringen einer vergrabenen Gitterstruktur in das Halbleitermaterial, insbesondere
Silizium, unter Verwendung einer metallischen Gittermaske,

d a d u r c h   g e k e n n z e i c h n e t ,

dass die vergrabene Gitterstruktur (10,11) mittels
gegendotierender Ionenimplantation ( 11 ) unter
Verwendung eines Hochenergiebeschleunigers durch die
metallische Gittermaske ( 5,8 ) hindurch unmittelbar
innerhalb des Halbleitermaterials ( 1 ) gebildet wird.

2. Verfahren nach Anspruch 1, dadurch gekennzeichnet,
dass der Hochenergiebeschleuniger im 80... 100 MeV-
Bereich arbeitet.

3. Verfahren nach Anspruch 1 oder 2, dadurch gekennzeichnet, dass die Eindringtiefe der Ionen zur Ausbildung der vergrabenen Gitterstruktur ( 10,11 ) größer
als 10μm, vorzugsweise größer als 50μm ist.

4. Verfahren nach einem der Ansprüche 1 bis 3, dadurch
gekennzeichnet, dass das Material und die Dicke der
Gittermaske ( 5,8 ) so gewählt werden, dass auch durch
die Stege ( 8 ) der Gittermaske ( 5 ) hindurch Ionen
( 9 ) im Halbleitermaterial ( 1 ) implantiert werden, so dass zwei vertikal separierte und seitlich gegeneinander versetzte vergrabene Gitterstrukturen ( 10,11 ) im Halbleitermaterial ausgebildet werden.

5. Verfahren nach einem der Ansprüche 1 bis 4, dadurch gekennzeichnet, dass die Umfangsfläche ( 6 ) des Halbleitermaterials ( 1 ) von dessen Oberseite ( 3 ) her unter einem spitzen Winkel($\alpha$) angeschliffen wird, dass die Steuer-/Schaltelektrode ( 4 ) auf der Unterseite ( 2 ) des Halbleitermaterials ( 1 ) ausgebildet wird und dass durch die Ionenimplantation ( 9 ) gleichzeitig parallel zu den Anschliffkanten (7) zwischen den vergrabenen Gitterstrukturen ( 10,11 ) und der Steuer-/Schaltelektrode ( 4 ) vergrabene Leiterstrukturen ( 12 ) bzw. ( 13 ) ausgebildet werden.

6. Verfahren nach Anspruch 5, dadurch gekennzeichnet, dass der Anschliffwinkel($\alpha$) zwischen 10 und 60° , vorzugsweise zwischen 10 und 30 ° beträgt.

7. Halbleiter-Leistungsbauelement, insbesondere Thyristor und Gridistor, mit einer im Halbleitermaterial vergrabenen Gitterstruktur und mit einer mit der vergrabenen Gitterstruktur leitend verbundenen Steuer-/ Schaltelektrode, dadurch gekennzeichnet, dass die Umfangsfläche ( 6 ) des Halbleitermaterials ( 1 ) von dessen Oberseite ( 3 ) her unter einem spitzen Winkel($\alpha$) angeschliffen ist, dass die Steuer-/Schaltelektrode ( 4 ) auf der Unterseite ( 2 ) des Halbleitermaterials ( 1 ) ausgebildet ist, dass zwei vertikal separierte und zueinander seitlich versetzte vergrabene Gitterstrukturen ( 10,11 ) in das Halbleitermaterial (1 ) implantiert sind und dass beide vergrabenen Gitterstrukturen ( 10,11 ) durch parallel zu den Anschliffflächen ( 6 ) im Halbleitermaterial verlaufende Leiterstrukturen ( 12,13 ) mit der Steuer-/Schaltelektrode
( 4 ) verbunden sind.

8. Halbleiter-Leistungselement nach Anspruch 7,
dadurch gekennzeichnet, dass der Anschliffwinkel$(\alpha)$
zwischen 10 und 60°, vorzugsweise zwischen 10 und
30 ° beträgt.

9. Halbleiter-Leistungsbauelement nach einem der
Ansprüche 7 und 8, dadurch gekennzeichnet, dass
der Querschnitt kegelstumpfförmig ist.

# Fig.1

# Fig.2

# Fig.3

# Fig.4

0153902

Fig.5

90°

Fig.6